# FASCICULE DE BREVET EUROPEEN

(11) **EP 4 327 370 B1**
(45) Date de publication et mention de la délivrance du brevet: **01.01.2025**
(21) Numéro de dépôt: 22720951.7
(22) Date de dépôt: 04.04.2022
(51) Int. Cl.: H01L 31/032, H01L 31/18, C23C 14/28

(54) **PROCÉDÉ DE FABRICATION D'UN DISPOSITIF OPTOÉLECTRONIQUE OU PHOTOVOLTAÏQUE, ET DISPOSITIF RÉALISÉ PAR CE PROCÉDÉ**
VERFAHREN ZUR HERSTELLUNG EINER OPTOELEKTRONISCHEN ODER FOTOVOLTAISCHEN VORRICHTUNG UND MIT DIESEM VERFAHREN HERGESTELLTE VORRICHTUNG
PROCESS FOR MANUFACTURING AN OPTOELECTRONIC OR PHOTOVOLTAIC DEVICE, AND DEVICE MADE BY SAID PROCESS

(30) Priorité: 20.04.2021 FR 2104098
(43) Date de publication de la demande: 28.02.2024
(73) Titulaire: Commissariat à l'Energie Atomique et aux Energies Alternatives, 75015 Paris (FR)
(72) Inventeur: DUPONT, Florian, 38054 GRENOBLE Cedex 09 (FR)
(74) Mandataire: Cabinet Beaumont
(86) Numéro de dépôt international: PCT/EP2022/058880
(87) Numéro de publication internationale: WO 2022/223273

(56) Documents cités:
- EP-A1- 3 435 418
- EP-A1- 3 650 576
- WO-A1-2016/203724
- WO-A1-2018/070791
- WO-A1-2018/086114
- WO-A1-2019/106370

## Description

La présente demande est basée sur, et revendique la priorité de, la demande de brevet français N° FR2104098 déposée le 20 avril 2021 et ayant pour titre "Procédé de fabrication d'un dispositif optoélectronique ou photovoltaïque, et dispositif réalisé par ce procédé".

### Domaine technique

La présente description concerne de façon générale les dispositifs optoélectroniques ou photovoltaïques. Elle vise plus particulièrement un procédé de fabrication d'un dispositif optoélectronique ou photovoltaïque à base d'un matériau pérovskite, et un dispositif réalisé par ce procédé.

### Technique antérieure

On a déjà proposé des dispositifs optoélectroniques ou photovoltaïques de type diode, réalisés à base de matériaux pérovskites. Notamment, le document WO 2016/203724 A1 décrit un dispositif optoélectronique constitué d'un empilement vertical comprenant une couche active à base d'un matériau pérovskite disposée entre deux couches de transport de charges, lesdites couches pouvant être formées par dépôt PLD.

Les dispositifs connus de ce type présentent toutefois divers inconvénients. En particulier, ces dispositifs souffrent généralement de problèmes de fiabilité et présentent des durées de vie relativement faibles. Résumé de l'invention

Un objet d'un mode de réalisation est de pallier tout ou partie des inconvénients des dispositifs optoélectroniques ou photovoltaïques connus à base de matériaux pérovskites.

Pour cela, un mode de réalisation selon l'invention prévoit un procédé de fabrication d'un dispositif optoélectronique ou photovoltaïque, comprenant les étapes successives suivantes :
a) former, par dépôt PLD, une couche active comprenant un matériau pérovskite sur la face supérieure d'une première couche de transport de charges ;
b) déposer, par dépôt PLD, une deuxième couche de transport de charges en un matériau inorganique sur la face supérieure de la couche active.

Selon l'invention, les étapes a) et b) sont mises en oeuvre sous vide, c'est-à-dire à une pression inférieure à la pression atmosphérique, le procédé ne comportant pas de rupture du vide entre les étapes a) et b).

Selon un mode de réalisation, la première couche de transport de charges est déposée par dépôt PLD avant l'étape a) .

Selon un mode de réalisation, l'étape de dépôt de la première couche de transport de charges et l'étape a) sont mises en oeuvre sous vide, c'est-à-dire à une pression inférieure à la pression atmosphérique, le procédé ne comportant pas de rupture du vide entre ces deux étapes.

Selon un mode de réalisation, le procédé comporte en outre, avant le dépôt de la première couche de transport de charges, une étape de dépôt d'une électrode inférieure, par exemple par dépôt PLD, la première couche de transport de charges étant ensuite déposée sur la face supérieure de l'électrode inférieure.

Selon un mode de réalisation, le procédé comporte en outre, après l'étape b), une étape de dépôt d'une électrode supérieure, par exemple par dépôt PLD, sur la face supérieure de la deuxième couche de transport de charges.

Selon un mode de réalisation, l'électrode supérieure est en un matériau conducteur transparent.

Selon un mode de réalisation, la deuxième couche de transport de charges est en dioxyde de titane, en dioxyde d'étain, en oxyde de nickel ou en oxyde de cuivre.

Selon un mode de réalisation, le matériau pérovskite de la couche active est un matériau pérovskite inorganique.

Selon un mode de réalisation, le matériau pérovskite de la couche active est un matériau pérovskite halogène inorganique.

Selon un mode de réalisation, avant l'étape a), la première couche de transport de charges est déposée sur la face supérieure d'un circuit intégré préalablement formé dans et sur un substrat semiconducteur, par exemple un substrat en silicium.

Un autre mode de réalisation selon l'invention prévoit un dispositif optoélectronique ou photovoltaïque comprenant un empilement vertical comprenant une première couche de transport de charges, une couche active comprenant un matériau pérovskite disposée sur la face supérieure de la première couche de transport de charges, et une deuxième couche de transport de charges en un matériau inorganique disposée sur la face supérieure de la couche active.

Selon un mode de réalisation, la première couche de transport de charges est disposée sur la face supérieure d'un circuit intégré formé dans et sur un substrat semiconducteur, par exemple un substrat en silicium.

Selon l'invention, la couche active et la deuxième couche de transport de charges ont des structures cristallines alignées selon une relation d'épitaxie.

Selon un mode de réalisation, la couche active est une monocouche massive en ledit matériau pérovskite.

Selon l'invention, la couche active est un empilement de puits quantiques multiples constitué par une alternance de couches de puits quantiques en ledit matériau pérovskite et de couches barrières en un autre matériau semiconducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique un exemple d'un dispositif optoélectronique ou photovoltaïque selon un mode de réalisation ; et
la figure 2 est un diagramme représentant schématiquement, sous forme de blocs, un exemple d'un procédé de fabrication du dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation complète des dispositifs optoélectroniques ou photovoltaïques décrits, et notamment de leurs éventuels circuits de contrôle, n'a pas été détaillée, la réalisation de ces dispositifs étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

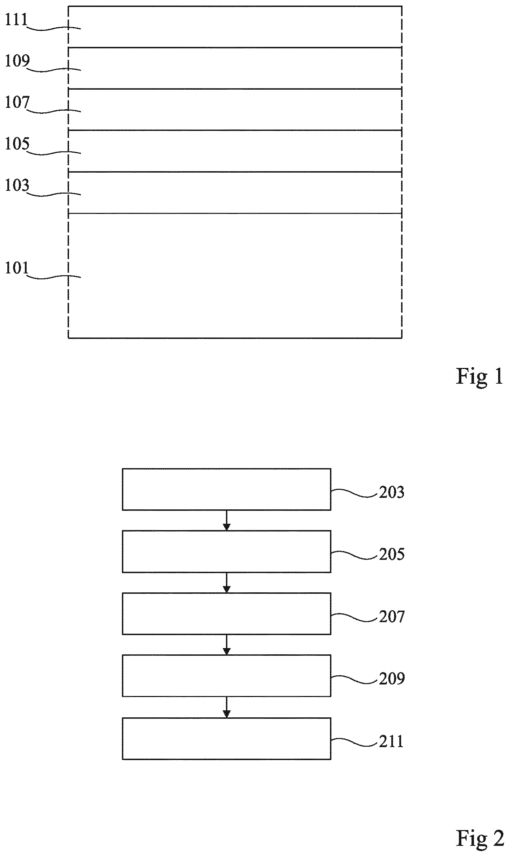

La figure 1 est une vue en coupe illustrant de façon schématique un exemple d'un dispositif optoélectronique ou photovoltaïque selon un mode de réalisation.

Le dispositif de la figure 1 est un dispositif de type diode, par exemple une diode électroluminescente, une photodiode, ou une diode photovoltaïque. Les modes de réalisation décrits sont tout particulièrement avantageux pour la réalisation de diodes électroluminescentes, et, plus particulièrement, pour la réalisation de diodes électroluminescentes de pixels de micro-écrans.

Le dispositif de la figure 1 comprend un substrat de support 101, par exemple un substrat semiconducteur, par exemple un substrat en silicium.

Le dispositif de la figure 1 comprend en outre un empilement vertical comportant, dans l'ordre à partir de la face supérieure du substrat, une première couche d'électrode 103, une première couche de transport de charges 105, une couche active 107, une deuxième couche de transport de charges 109, et une deuxième couche d'électrode 111.

La couche d'électrode inférieure 103 est par exemple en contact, par sa face inférieure, avec la face supérieure du substrat 101. La première couche de transport de charges 105 est par exemple en contact, par sa face inférieure, avec la face supérieure de la couche d'électrode 103. La couche active 107 est par exemple en contact, par sa face inférieure, avec la face supérieure de la couche de transport de charges 105. La deuxième couche de transport de charges 109 est par exemple en contact, par sa face inférieure, avec la face supérieure de la couche active 107. La couche d'électrode supérieure 111 est par exemple en contact, par sa face inférieure, avec la face supérieure de la couche de transport de charges 109.

Selon l'invention, la couche active 107 comprend un matériau à structure pérovskite.

Un avantage est que les matériaux à structure pérovskite, aussi appelés matériaux pérovskites, présentent une efficacité quantique interne élevée, pouvant aller jusqu'à 100%. En outre, les matériaux pérovskite présentent un coefficient d'absorption élevé. Ainsi, la fonction de conversion photo-électrique (dans le cas d'une photodiode ou d'une diode photovoltaïque) ou électro-photonique (dans le cas d'une diode électroluminescente) peut être assurée efficacement par une couche active d'épaisseur relativement faible.

Du fait des faibles épaisseurs requises pour assurer les fonctions de conversion recherchées, la couche active 107 peut être gravée facilement, ce qui permet de réaliser des éléments de conversion ou d'émission lumineuse présentant de très petites dimensions latérales. Les modes de réalisation décrits sont notamment particulièrement avantageux pour la réalisation de diodes dans des pixels de petites dimensions, par exemple pour la réalisation de dispositifs (par exemple un écran d'affichage d'images) présentant un pas inter-pixel inférieur à 100 µm, par exemple inférieur à 20 µm, voire inférieur à 5 µm.

Un autre avantage est que les matériaux pérovskites peuvent être déposés à des températures relativement basses, par exemple inférieures ou égales à 400°C, ce qui permet notamment leur dépôt sur un circuit intégré, par exemple de type CMOS (de l'anglais "Complementary Métal Oxide Semiconductor" - métal oxyde semiconducteur complémentaire).

Un autre avantage est que les matériaux pérovskites présentent une grande tolérance aux défauts de structure cristalline.

Selon l'invention, la couche active 107 est un empilement à puits quantiques multiples comprenant une alternance de couches semiconductrices d'un premier matériau et de couches semiconductrices d'un deuxième matériau, chaque couche du premier matériau étant prise en sandwich entre deux couches du deuxième matériau. Le premier matériau est un matériau pérovskite et présente une bande interdite plus étroite que celle du deuxième matériau. Chaque couche du premier matériau définit un puits quantique. Les couches du deuxième matériau sont des barrières quantiques. Le nombre de puits quantiques de l'empilement est de préférence supérieur ou égal à 2, par exemple supérieur ou égal à 3. Le matériau des couches barrières 103 est de préférence un matériau semiconducteur inorganique, par exemple un composé III-V comprenant au moins un premier élément du groupe III, un deuxième élément du groupe V, et, éventuellement, un troisième élément, par exemple un élément du groupe III autre que le premier élément. A titre d'exemple, l'élément du groupe V est l'azote (N), de sorte que le matériau des couches barrières comprend un composé III-N. A titre d'exemple, le matériau des couches barrières est du nitrure de gallium, du nitrure d'aluminium, du nitrure de bore, du nitrure d'indium ou un alliage d'un ou plusieurs de ces matériaux. L'épaisseur des couches du premier matériau est choisie de façon à permettre un confinement quantique dans chaque couche de puits quantique. A titre d'exemple, chaque couche du premier matériau présente une épaisseur comprise entre 1 et 50 nm. Chaque couche barrière présente par exemple une épaisseur comprise entre 1 et 100 nm.

Afin d'obtenir de bonnes performances de conversion ou d'émission lumineuse et une durée de vie importante, le matériau pérovskite de la couche active 107 est de préférence un matériau pérovskite inorganique.

A titre d'exemple, on pourra utiliser un matériau pérovskite à base de césium, de plomb et d'un ou plusieurs halogènes, par exemple du CsPbI₂Br, du CsPbBr₃, du CsPbCl₃, du CsSnBr₃, ou encore du CsPbI₃. A titre de variante, on pourra utiliser un matériau pérovskite hybride de type MAPbI₃. Plus généralement, d'autres matériaux pérovskites peuvent être choisis en fonction des propriétés d'absorption ou d'émission recherchées.

De façon générale, on utilisera de préférence un matériau pérovskite dit halogène inorganique, c'est-à-dire de type ABX₃, où :
- A est un élément inorganique, par exemple du césium (Cs), du plomb (Pb), du phosphore (K) ou du lithium (Li),
- B est du plomb (Pb) de l'étain (Sn) ou du germanium (Ge), et
- X est un halogène, par exemple le brome (Br), le chlore (Cl), l'iode (I) ou une combinaison d'halogènes.

A titre de variante, le matériau pérovskite de la couche active 107 est un matériau pérovskite organique, par exemple du formadiminium, aussi appelé FA, de formule chimique CN₂H₅₊, ou du Methylammonium, aussi appelé MA, de formule chimique CH₃NH₃₊, ou une combinaison de ces éléments.

Selon un aspect des modes de réalisation décrit, les couches de transport de charge inférieure 105 et supérieure 109 sont toutes deux en des matériaux inorganiques. L'encapsulation de la couche active 107 par des couches 105 et 109 inorganiques permet d'améliorer la stabilité dans le temps du matériau pérovskite de la couche 107, et donc la fiabilité et la durée de vie du dispositif.

A titre d'exemple, la couche 105 est une couche de transport d'électrons et la couche 109 est une couche de transport de trous. La couche 105 est par exemple en dioxyde de titane (TiO₂) ou en dioxyde d'étain (SnO₃). La couche 109 est par exemple oxyde de nickel (NiO) ou en oxyde de cuivre (Cu₂O). Les couches 105 et 109 permettent d'injecter ou de collecter du courant dans la couche active 107 de façon à provoquer l'émission de lumière par la diode ou à collecter un courant photo-généré. A titre de variante, les couches 105 et 109 peuvent être inversées.

La couche d'électrode inférieure 103 est par exemple une couche métallique, de préférence une couche métallique réfléchissante. La couche 103 est par exemple en platine.

La couche d'électrode supérieure 111 est de préférence une couche conductrice transparente dans la gamme de longueurs d'onde de fonctionnement du dispositif optoélectronique ou photovoltaïque. La couche 111 est par exemple en un oxyde conducteur transparent, par exemple en oxyde d'indium-étain (ITO), en oxyde de zinc (ZNO), ou en oxyde de zinc-gallium (GZO). La couche 111 peut être dopée à l'aluminium ou au cadmium. La couche 111 peut être recouverte d'une couche de passivation, non représentée, par exemple en nitrure de silicium.

La figure 2 est un diagramme représentant schématiquement, sous forme de blocs, un exemple d'un procédé de fabrication du dispositif de la figure 1.

Le procédé de la figure 2 comprend des étapes successives de dépôt des couches 103, 105, 107, 109 et 111 sur la face supérieure du substrat 101. Dans un mode de réalisation préféré, le substrat 101 intègre un circuit de contrôle de la diode formée par l'empilement des couches 103, 105, 107, 109 et 111. En effet, un avantage du procédé de la figure 2 est qu'il peut être entièrement mis en oeuvre à des températures relativement basses, par exemple inférieures ou égales à 400°C, compatibles avec un dépôt sur un circuit intégré préalablement formé dans et sur un substrat semiconducteur, par exemple un substrat en silicium. A titre d'exemple, le substrat 101 est un circuit intégré de type CMOS. A titre d'exemple, une pluralité de diodes, par exemple identiques ou similaires, par exemple commandables individuellement, sont formées sur la face supérieure du substrat 101. Les diodes définissent par exemple des pixels du dispositif et sont par exemple connectées respectivement à différents plots de connexion électrique du circuit intégré.

Lors d'une étape 203, la couche d'électrode inférieure 103 est déposée sur la face supérieure du substrat 101, par exemple par évaporation ou par pulvérisation.

Lors d'une étape 205 postérieure à l'étape 203, la couche de transport de charges inférieure 105 est déposée sur la face supérieure de la couche d'électrode inférieure 103. De préférence, la couche 105 est déposée par dépôt PLD (de l'anglais "Pulsed Laser Déposition" - dépôt laser pulsé) aussi appelé dépôt par ablation laser pulsée. Le dépôt PLD consiste à pulvériser ou ablater la surface d'une cible du matériau à déposer au moyen d'un laser pulsé, de manière à transférer le matériau dans un plasma, puis, via le plasma, sur le substrat de destination. Un avantage du dépôt PLD est qu'il permet de déposer des matériaux complexes avec une bonne qualité cristalline, et ce à une température relativement basse, par exemple inférieure ou égale à 400°C, sans endommager le substrat de destination.

A titre de variante, la couche de transport de charges inférieure 105 est déposée par une autre méthode de dépôt, par exemple par évaporation ou par pulvérisation, par exemple à une température inférieure ou égale à 400°C.

Lors d'une étape 207 postérieure à l'étape 205, la couche active 107 est déposée sur la face supérieure de la couche de transport de charges 105. La couche active 107 est déposée par dépôt PLD.

Les couches de puits quantiques et les couches barrières sont par exemple successivement déposées par PLD, sans rupture du vide, c'est-à-dire en maintenant toujours le substrat dans une enceinte à basse pression, c'est-à-dire à une pression inférieure à la pression atmosphérique, par exemple à une pression inférieure ou égale à 1 mbar entre les étapes successives de dépôt. Ceci permet de ne pas exposer à l'air, à l'humidité, à l'oxygène ou aux impuretés les différentes couches de l'empilement entre les dépôts successifs. A titre d'exemple, les couches de puits quantiques et les couches barrières sont successivement déposées par PLD sans extraire le substrat destination de la chambre de dépôt entre deux étapes successives de dépôt. En effet, un avantage du dépôt PLD est qu'il permet de commuter entre différentes cibles de matériaux de compositions différentes sans extraire le substrat destination de la chambre de dépôt. Un autre avantage est que le dépôt PLD est une méthode de dépôt douce. Autrement dit, le dépôt PLD se caractérise par un atterrissage doux ("soft landing" en anglais) des atomes de la cible sur le substrat destination. Ceci permet en particulier de ne pas endommager le matériau pérovskite des couches de puits quantiques lors du dépôt des couches barrières.

Lors d'une étape 209 postérieure à l'étape 207, la couche de transport de charges supérieure 109 est déposée sur la face supérieure de la couche active 107. La couche 109 est déposée par dépôt PLD. En effet, un avantage du dépôt PLD est qu'il permet de déposer une couche de transport de charges en un matériau inorganique sur la couche active 107, sans endommager le matériau pérovskite de la couche 107, et ce grâce au fait que le dépôt PLD permet un atterrissage doux des atomes de la cible sur la surface de destination. La couche active 107 et la couche de transport de charges supérieure 109 sont successivement déposées par dépôt PLD sans rupture du vide entre le dépôt de la couche 107 et le dépôt de la couche 109. Ceci permet de ne pas exposer à l'air, à l'oxygène ou aux impuretés la couche 107 avant le dépôt de la couche 109. A titre d'exemple, la couche 107 et la couche 109 sont successivement déposées par dépôt PLD sans changer d'équipement de dépôt et sans extraire le substrat de la chambre de dépôt entre le dépôt de la couche 107 et le dépôt de la couche 109.

Plus préférentiellement, la couche de transport de charges inférieure, la couche active 107 et la couche de transport de charges supérieure 109 sont successivement déposées par dépôt PLD sans rupture du vide entre les dépôts des différentes couches, par exemple sans changer d'équipement de dépôt et sans extraire le substrat de la chambre de dépôt entre les dépôts des différentes couches.

A titre d'exemple, le dépôt de la couche de transport de charges supérieure 109 comprend au moins une première phase pendant laquelle la pression dans la chambre de dépôt est relativement élevée, par exemple supérieure à 0,01 mbar, de préférence comprise entre 0,1 et 0,2 mbar. Ceci permet d'assurer un atterrissage doux des atomes de la cible sur la surface de la couche active 107 et ainsi de ne pas détériorer la couche active 107. Au moins pendant cette première phase, l'atmosphère de la chambre de dépôt est de préférence dépourvue d'oxygène, par exemple essentiellement constituée d'argon et/ou de diazote, de façon à ne pas oxyder la couche active 107. Après cette première phase, la pression peut être abaissée, par exemple à environ 0,001 mbar.

Un autre avantage du dépôt PLD est qu'il permet d'épitaxier les matériaux déposés. Autrement dit, les couches déposées présentent une continuité latérale (c'est-à-dire dans le plan horizontal dans l'orientation de la figure 1) de la structure cristalline, ou un alignement cristallin vertical entre les différentes couches déposées. Ceci permet notamment d'améliorer la stabilité dans le temps du dispositif en général, et en particulier du matériau pérovskite. La couche active 107 et la couche de transport de charges supérieure 109 sont toutes deux épitaxiées. De préférence, la couche de transport de charges inférieure 105, la couche active 107 et la couche de transport de charges supérieure 109 sont toutes trois épitaxiées.

Lors d'une étape 211 postérieure à l'étape 209, la couche d'électrode supérieure 111 est déposée sur la face supérieure de la couche de transport de charges 109, par exemple par évaporation ou par pulvérisation.

A titre de variante, la couche d'électrode supérieure 111 est déposée par dépôt PLD, de façon à obtenir une couche 111 épitaxiée. De préférence, la couche 109 et la couche 111 sont alors successivement déposées par dépôt PLD sans rupture de vide entre les deux dépôts, par exemple sans extraire le substrat de la chambre de dépôt entre les deux dépôts.

De façon similaire, la couche d'électrode inférieure 103 peut être déposée par dépôt PLD à l'étape 203.

Dans un mode de réalisation particulièrement avantageux, les couches 103, 105, 107, 109 et 111 sont toutes les cinq déposées par PLD, de façon à obtenir un empilement entièrement épitaxié, de préférence sans rupture du vide entre les dépôts des différentes couches.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit-ci-dessus la réalisation d'une diode unique, la personne du métier saura mettre en oeuvre des procédés permettant de réaliser simultanément plusieurs diodes adressables individuellement, correspondant par exemple à différents pixels d'un micro-écran ou d'un capteur d'images monolithique, en utilisant des procédés de gravure localisée ou de dépôt localisé pour isoler électriquement les diodes les unes des autres.

Par ailleurs, la personne du métier saura, en utilisant des procédés de gravure localisée ou de dépôt localisé, réaliser, sur un même substrat, plusieurs diodes à bases de matériaux pérovskites distincts, correspondant à différents pixels d'un micro-écran émettant à des longueurs d'ondes distinctes, ou à différents pixels d'un capteur d'image sensibles dans des gammes de longueurs d'ondes distinctes.

En outre, dans l'exemple de réalisation décrit ci-dessus en relation avec la figure 1, le substrat 101 et l'électrode inférieure 103 sont opaques, les modes de réalisation décrits ne se limitent toutefois pas à ce cas particulier. A titre de variante, le substrat 101 et l'électrode inférieure 103 peuvent être transparents. L'électrode supérieure 111 peut alors être soit opaque, soit transparente.

En outre, la personne du métier saura prévoir un dispositif de type tandem, par exemple un dispositif photovoltaïque, comportant, entre l'électrode inférieure 103 et l'électrode supérieure 111, une première diode formée par l'empilement des couches 105, 107 et 109, et une deuxième diode constituée par un empilement d'une troisième couche de transport, d'une couche active et d'une quatrième couche de transport de charge, non représentées.

Par ailleurs, bien que l'on ait décrit ci-dessus des exemples de réalisation de diodes planaires, les modes de réalisation pourront être adaptés à des dispositifs à base de diodes tridimensionnelles, par exemple des LED à base de nanofils ou de microfils semiconducteurs, ou encore des LED pyramidales, par exemple du type décrit dans la demande de brevet FR3087942 ou dans la demande de brevet FR3089687 précédemment déposées par le demandeur.

## Revendications

1. Procédé de fabrication d'un dispositif optoélectronique ou photovoltaïque, comprenant les étapes successives suivantes :
a) former, par dépôt laser pulsé (PLD), une couche active (107) comprenant un matériau pérovskite sur la face supérieure d'une première couche de transport de charges (105) ;
b) déposer, par dépôt PLD, une deuxième couche de transport de charges (109) en un matériau inorganique sur la face supérieure de la couche active,
dans lequel les étapes a) et b) sont mises en oeuvre sous vide, c'est-à-dire à une pression inférieure à la pression atmosphérique, le procédé ne comportant pas de rupture du vide entre les étapes a) et b),
**caractérisé en ce que** la couche active (107) est un empilement de puits quantiques multiples constitué par une alternance de couches de puits quantiques en ledit matériau pérovskite et de couches barrières en un autre matériau semiconducteur.

2. Procédé selon la revendication 1, dans lequel la première couche de transport de charges (105) est déposée par dépôt PLD avant l'étape a).

3. Procédé selon la revendication 2, dans lequel l'étape de dépôt de la première couche de transport de charges (105) et l'étape a) sont mises en oeuvre sous vide, c'est-à-dire à une pression inférieure à la pression atmosphérique, le procédé ne comportant pas de rupture du vide entre ces deux étapes.

4. Procédé selon la revendication 2 ou 3, comportant en outre, avant le dépôt de la première couche de transport de charges (105), une étape de dépôt d'une électrode inférieure (103), par exemple par dépôt PLD, la première couche de transport de charges (105) étant ensuite déposée sur la face supérieure de l'électrode inférieure (103).

5. Procédé selon l'une quelconque des revendications 1 à 4, comportant en outre, après l'étape b), une étape de dépôt d'une électrode supérieure (111), par exemple par dépôt PLD, sur la face supérieure de la deuxième couche de transport de charges (109).

6. Procédé selon la revendication 5, dans lequel l'électrode supérieure (111) est en un matériau conducteur transparent.

7. Procédé selon l'une quelconque des revendications 1 à 6, dans lequel la deuxième couche de transport de charges (109) est en dioxyde de titane, en dioxyde d'étain, en oxyde de nickel ou en oxyde de cuivre.

8. Procédé selon l'une quelconque des revendications 1 à 7, dans lequel le matériau pérovskite de la couche active (107) est un matériau pérovskite inorganique.

9. Procédé selon la revendication 8, dans lequel le matériau pérovskite de la couche active (107) est un matériau pérovskite halogène inorganique.

10. Procédé selon l'une quelconque des revendications 1 à 9, dans lequel, avant l'étape a), la première couche de transport de charges (105) est déposée sur la face supérieure d'un circuit intégré préalablement formé dans et sur un substrat semiconducteur, par exemple un substrat en silicium.

11. Dispositif optoélectronique ou photovoltaïque comprenant un empilement vertical comprenant une première couche de transport de charges (105), une couche active (107) comprenant un matériau pérovskite disposée sur la face supérieure de la première couche de transport de charges, et une deuxième couche de transport de charges (109) en un matériau inorganique disposée sur la face supérieure de la couche active,
dans lequel la couche active (107) et la deuxième couche de transport de charges (109) ont des structures cristallines alignées selon une relation d'épitaxie,
**caractérisé en ce que** la couche active (107) est un empilement de puits quantiques multiples constitué par une alternance de couches de puits quantiques en ledit matériau pérovskite et de couches barrières en un autre matériau semiconducteur.

12. Dispositif selon la revendication 11, dans lequel la première couche de transport de charges (105) est disposée sur la face supérieure d'un circuit intégré formé dans et sur un substrat semiconducteur, par exemple un substrat en silicium.

## Patentansprüche

1. Verfahren zur Herstellung einer optoelektronischen oder photovoltaischen Vorrichtung, das die folgenden aufeinanderfolgenden Schritte aufweist:
a) Ausbilden einer aktiven Schicht (107), die ein Perowskit-Material aufweist, auf der Oberseite einer ersten Ladungstransportschicht (105) durch gepulste Laserabscheidung (PLD);
b) Abscheiden einer zweiten Ladungstransportschicht (109) aus einem anorganischen Material auf der Oberseite der aktiven Schicht durch PLD,
wobei die Schritte a) und b) in einem Vakuum, d.h. bei einem Druck unterhalb des Atmosphärendrucks, durchgeführt werden, wobei das Verfahren keine Vakuumpause zwischen den Schritten a) und b) beinhaltet,
**dadurch gekennzeichnet, dass** die aktive Schicht (107) ein Stapel von Mehrfach-Quantentöpfen ist, der aus abwechselnden Quantentopfschichten aus dem Perowskit-Material und Sperrschichten aus einem anderen Halbleitermaterial besteht.

2. Verfahren nach Anspruch 1, wobei die erste Ladungstransportschicht (105) vor Schritt a) durch PLD abgeschieden wird.

3. Verfahren nach Anspruch 2, wobei der Schritt des Abscheidens der ersten Ladungstransportschicht (105) und Schritt a) unter Vakuum, d.h. bei einem Druck, der niedriger als der Atmosphärendruck ist, durchgeführt werden, wobei das Verfahren keine Vakuumpause zwischen diesen beiden Schritten beinhaltet.

4. Verfahren nach Anspruch 2 oder 3, das ferner vor dem Abscheiden der ersten Ladungstransportschicht (105) einen Schritt des Abscheidens einer unteren Elektrode (103), zum Beispiel durch PLD-Abscheidung, aufweist, wobei die erste Ladungstransportschicht (105) dann auf der Oberseite der unteren Elektrode (103) abgeschieden wird.

5. Verfahren nach einem der Ansprüche 1 bis 4, das ferner nach Schritt b) einen Schritt des Abscheidens einer oberen Elektrode (111), beispielsweise durch PLD-Abscheidung, auf der Oberseite der zweiten Ladungstransportschicht (109) aufweist.

6. Verfahren nach Anspruch 5, wobei die obere Elektrode (111) aus einem transparenten leitfähigen Material besteht.

7. Verfahren nach einem der Ansprüche 1 bis 6, wobei die zweite Ladungstransportschicht (109) aus Titandioxid, Zinndioxid, Nickeloxid oder Kupferoxid hergestellt ist.

8. Verfahren nach einem der Ansprüche 1 bis 7, wobei das Perowskit-Material der aktiven Schicht (107) ein anorganisches Perowskit-Material ist.

9. Verfahren nach Anspruch 8, wobei das Perowskit-Material der aktiven Schicht (107) ein anorganisches Halogen-Perowskit-Material ist.

10. Verfahren nach einem der Ansprüche 1 bis 9, wobei vor Schritt a) die erste Ladungstransportschicht (105) auf der Oberseite einer integrierten Schaltung abgeschieden wird, die zuvor in und auf einem Halbleitersubstrat, beispielsweise einem Siliziumsubstrat, ausgebildet wurde.

11. Optoelektronische oder photovoltaische Vorrichtung mit einem vertikalen Stapel, der eine erste Ladungstransportschicht (105), eine aktive Schicht (107), die ein Perowskit-Material aufweist, das auf der Oberseite der ersten Ladungstransportschicht angeordnet ist, und eine zweite Ladungstransportschicht (109) aus einem anorganischen Material aufweist, die auf der Oberseite der aktiven Schicht angeordnet ist,
wobei die aktive Schicht (107) und die zweite Ladungstransportschicht (109) Kristallstrukturen aufweisen, die in einer epitaktischen Beziehung ausgerichtet sind,
**dadurch gekennzeichnet, dass** die aktive Schicht (107) ein Stapel von Mehrfach-Quantentöpfen ist, der aus abwechselnden Quantentopfschichten aus dem Perowskit-Material und Sperrschichten aus einem anderen Halbleitermaterial besteht.

12. Vorrichtung nach Anspruch 11, wobei die erste Ladungstransportschicht (105) auf der Oberseite einer integrierten Schaltung angeordnet ist, die in und auf einem Halbleitersubstrat, beispielsweise einem Siliziumsubstrat, ausgebildet ist.

## Claims

1. A method of manufacturing an optoelectronic or photovoltaic device, comprising the following successive steps:
a) forming, by pulsed laser deposition (PLD), an active layer (107) comprising a perovskite material on the upper side of a first charge transport layer (105) ;
b) depositing, by PLD, a second charge-transport layer (109) of an inorganic material on the upper face of the active layer,
wherein steps a) and b) are carried out in a vacuum, i.e. at a pressure below atmospheric pressure, the method including no vacuum break between steps a) and b),
**characterized in that** the active layer (107) is a stack of multiple quantum wells consisting of alternating quantum well layers of said perovskite material and barrier layers of another semiconductor material.

2. The method of claim 1, wherein the first charge transport layer (105) is deposited by PLD prior to step a).

3. The method of claim 2, wherein the step of depositing the first charge transport layer (105) and step a) are carried out under vacuum, i.e. at a pressure lower than atmospheric pressure, the process including no vacuum break between these two steps.

4. The method of claim 2 or 3, further comprising, prior to deposition of the first charge transport layer (105), a step of depositing a lower electrode (103), for example by PLD deposition, the first charge transport layer (105) then being deposited on the upper face of the lower electrode (103) .

5. The method of any of claims 1 to 4, further comprising, after step b), a step of depositing a top electrode (111), for example by PLD deposition, on the top face of the second charge transport layer (109).

6. The method of claim 5, in which the top electrode (111) is made of a transparent conductive material.

7. The method of any of claims 1 to 6, wherein the second charge-transport layer (109) is made of titanium dioxide, tin dioxide, nickel oxide or copper oxide.

8. The method of any of claims 1 to 7, wherein the perovskite material of the active layer (107) is an inorganic perovskite material.

9. The method of claim 8, in which the perovskite material of the active layer (107) is an inorganic halogen perovskite material.

10. The method of any of claims 1 to 9, wherein, prior to step a), the first charge transport layer (105) is deposited on the top surface of an integrated circuit previously formed in and on a semiconductor substrate, for example a silicon substrate.

11. An optoelectronic or photovoltaic device comprising a vertical stack comprising a first charge transport layer (105), an active layer (107) comprising a perovskite material disposed on the upper side of the first charge transport layer, and a second charge transport layer (109) of an inorganic material disposed on the upper side of the active layer,
wherein the active layer (107) and the second charge transport layer (109) have crystal structures aligned in an epitaxial relationship,
**characterized in that** the active layer (107) is a stack of multiple quantum wells consisting of alternating quantum well layers of said perovskite material and barrier layers of another semiconductor material.

12. The device of claim 11, wherein the first charge transport layer (105) is arranged on the top side of an integrated circuit formed in and on a semiconductor substrate, for example a silicon substrate.
